Europäisches Patentamt

European Patent Office

Office européen des brevets

(19)

(11) Veröffentlichungsnummer: **0 388 592**
**A2**

## (12) EUROPÄISCHE PATENTANMELDUNG

(21) Anmeldenummer: **90101308.6**

(22) Anmeldetag: **23.01.90**

(51) Int. Cl.[5]: **G03G 13/28, G03F 7/42**

(30) Priorität: **31.01.89 DE 3902748**

(43) Veröffentlichungstag der Anmeldung:
**26.09.90 Patentblatt 90/39**

(84) Benannte Vertragsstaaten:
**AT CH DE FR GB IT LI NL**

(71) Anmelder: **HOECHST AKTIENGESELLSCHAFT**
**Postfach 80 03 20**
**D-6230 Frankfurt am Main 80(DE)**

(72) Erfinder: **Schell,Loni, Dipl.-Chem.**
**Erbacher Strasse 10**
**D-6238 Hofheim-Wallau(DE)**

(54) **Entschichtungslösung für elektrophotographisch bebilderte Platten und Verfahren zum Entschichten solcher Platten.**

(57) Die Erfindung betrifft eine wäßrig-alkalische, gegebenenfalls organische Lösemittel enthaltende Entschichtungslösung, die eine Verbindung der allgemeinen Formel $R\text{-}SO_3X$ enthält, wobei X ein einwertiges Kation ist und worin

A) $R = R^1 - O[CH_2 \bullet CH_2O]_n\text{-}$, $R^1$ = ein Kohlenwasserstoffrest mit 1 bis 6 C-Atomen und n = 1 bis 6 ist oder
R = Aryl- oder
R = Alkylarylbedeuten und die $\text{-}SO_3X$-Gruppe am Glykol- bzw. am Arylrest gebunden ist und

B) einen Anteil von 0 bis 15 Gew.-% an wenigstens einem höher als Wasser siedenden, organischen Lösemittel enthält.

Die Erfindung betrifft auch ein Verfahren zur Herstellung von auf elektrophotographischem Weg erzeugten Druckplatten, wobei die Photoleiterschicht mit der erfindungsgemäßen Entschichtungslösung behandelt wird.

EP 0 388 592 A2

## Entschichtungslösung für elektrophotographisch bebilderte Platten und verfahren zum Entschichten solcher Platten

Die Erfindung betrifft eine Entschichtungslösung für die Herstellung einer Flachdruckform aus einer vorbeschichteten Druckplatte, bestehend aus einem elektrisch leitenden Träger z. B. aus Aluminium, gegebenenfalls in elektrolytisch aufgerauhter und/oder anodisierter Form, und einer darauf aufgebrachten Photoleiterschicht, auf die ein Toner aufgebracht und thermofixiert ist.

Die Differenzierung in Bild- und Nichtbildbereiche wird bei der Elektrophotographie nicht durch Löslichkeitsänderung der Schicht beim Belichten erreicht, sondern durch Aufbringen eines Toners auf die bildmäßig aufgeladene Photoleiterschicht. Nach dem Fixieren des Toners bei erhöhter Temperatur bildet er eine Bildschablone. Ein Ablösen der Photoleiterschicht an den Bildstellen durch die Entschichtungslösung wird dadurch verhindert, während an den Nichtbildstellen eine Lösung eintritt und somit die Druckvorlage entsteht.

An die Entschichtungslösung wird die Anforderung gestellt, die Photoleiterschicht abzulösen, ohne den Toner anzugreifen. Dadurch wird das hydrophile Trägermaterial freigelegt, das im Druckprozeß keine Farbe überträgt, im Gegensatz zu den betonerten Bereichen.

Derartige Verfahren und Materialien sind bekannt aus den DE-C 11 17 391 (GB-A 944 126), 23 22 046 (= GB-A 1 465 926) und 25 26 720 (= GB-A 1 553 696). Zur Entschichtung der tonerfreien Nichtbildbereiche werden in diesen Schriften alkalische Lösungen von Silikaten, Phosphaten, Hydroxiden, Aminen und Aminoalkoholen beschrieben) die Ether, Ketone, Alkohole, Glykole und Glykolether enthalten.

Überwiegend gelangen heute Lösungen mit höheren Wasseranteilen zur Anwendung. In diesen werden kurzkettige, relativ leichtflüchtige Alkohole eingesetzt. Diese Alkohole sind jedoch unerwünscht, da sie feuer- und explosionsgefährlich sind und eine Umweltbelastung darstellen.

Als alternative Entschichter werden wäßrig-alkalische Lösungen verwendet, die neben schwerflüchtigen Lösemitteln größere Mengen Netzmittel enthalten. Diese Netzmittelanteile führen jedoch zu starkem, unerwünschtem Schaum in der Lösung. In diesen Lösungen bleiben aus der Photoleiterschicht Harzanteile ungelöst, die zusammen mit ungelöstem Photoleiter einen voluminösen Schlamm, der zum Kleben neigt, im Tank der Entschichtungsstation bilden. Durch diese klebenden Bestandteile wird ein hoher Reinigungsaufwand erforderlich. In einigen Fällen kommt es zu Redeponierungen auf Walzen und Platten, wodurch erhebliche Störungen bei der Herstellung einer einwandfreien Druckform hervorgerufen werden.

Aufgabe der vorliegenden Erfindung ist es, einen Entschichter zur Verfügung zu stellen, der kein leichtflüchtiges Lösemittel enthält und nach dessen Anwendung keine klebrigen Rückstände verbleiben.

Die Erfindung geht aus von einer wäßrig-alkalischen, gegebenenfalls organische Lösemittel enthaltenden Entschichtungslösung für die Herstellung von elektrophotographisch erzeugten Druckformen, wobei auf einem elektrisch leitenden hydrophilen Trägermaterial eine oleophile Photoleiterschicht, die einen Photoleiter und ein Bindemittel mit alkalilöslich oder quellbar machenden Gruppen enthält, angeordnet ist.

Die erfindungsgemäße Entschichtungslösung ist dadurch gekennzeichnet, daß sie eine Verbindung der allgemeinen Formel $R-SO_3X$ enthält, wobei X ein einwertiges Kation ist und worin

$R = R^1 - O(CH_2 \cdot CH_2 O)_n-$, $R^1$ = ein Kohlenwasserstoffrest mit 1 bis 6 C-Atomen und n = 1 bis 6 ist oder

$R$ = Aryl- oder

$R$ = Alkylarylbedeuten, die $-SO_3X$-Gruppe am Glykol- bzw. am Arylrest gebunden ist und die Lösung einen Anteil von 0 bis 15 Gew.-% an wenigstens einem höher als Wasser siedenden, organischen Lösemittel enthält.

Bevorzugt ist $R^1$ aus der allgemeinen Formel eine aliphatische Gruppe mit 4 C-Atomen, wobei n = 1 ist. Wenn R eine Arylgruppe darstellt, ist diese vorzugsweise eine Phenylgruppe, und wenn R eine Alkylarylgruppe darstellt, ist diese insbesondere eine mono- oder disubstituierte Phenylgruppe mit 1 bis 3 C-Atomen im Alkylsubstituenten.

Der Anteil der höher als Wasser siedenden organischen Lösemittel in der Lösung beträgt insbesondere 1,0 bis 5,0 Gew.-%.

Bevorzugt werden als organische Lösemittel höher siedende Alkohole bzw. Gemische von Alkoholen oder höher siedende Glykolether bzw. Gemische von Glykolethern oder auch Gemische von entsprechenden Alkoholen und Glykolethern eingesetzt. Vor allem kommen Benzylakohol und Ethylenglykolmonophenylether oder Diethylenglykolmonoethylether bzw. Gemische davon zum Einsatz.

Als alkalisch machende Substanzen können grundsätzlich alle alkalischen Verbindungen auf anorganischer und/oder organischer Basis eingesetzt werden, unter der Voraussetzung, daß sie mit den übrigen Komponenten verträglich sind.

Die alkalisch machenden Substanzen werden in einem Anteil von 0,1 bis 10,0 Gew.-%, vorzugsweise von 1,0 bis 5,0 Gew.-%, in der wäßrigen Lösung eingesetzt.

Als alkalisch machende organische Substanzen werden vorzugsweise Aminoalkohole, als anorganische Substanzen vorzugsweise alkalisch reagierende Salze von starken Basen und schwachen Säuren, wie z. B. Alkalisilikate oder Alkalicitrate und Gemische daraus, verwendet.

In der Entschichtungslösung können zur besseren Benetzung auch Netzmittel, vorzugsweise im Bereich von 0,2 bis 2,0 Gew.-% , und - zur Unterdrückung einer Schaumbildung bei der Plattenbehandlung - Entschäumer, vorzugsweise im Bereich von 0,01 bis 1,0 Gew.-%, zugefügt werden.

Zur Stabilisierung bestimmter pH-Werte werden insbesondere Puffersubstanzen, wie z. B. Alkaliphosphate, in die Lösung eingearbeitet. Der Anteil liegt dann bei 0,01 bis 0,1 mol/l.

Die vorliegende Erfindung betrifft auch ein Verfahren zur Herstellung einer Druckform, wobei man eine auf einem elektrisch leitenden hydrophilen Trägermaterial befindliche, oleophile Photoleiterschicht, die einen Photoleiter und ein Bindemittel mit alkalilöslich oder quellbar machenden Gruppen enthält, gleichmäßig auflädt, bildmäßig belichtet, betonert, die Tonerschicht thermisch fixiert und anschließend die nicht mit Toner versehene Photoleiterschicht mit einer wäßrig-alkalischen, gegebenenfalls organische Lösemittel enthaltenden Entschichtungslösung entfernt, dessen kennzeichnendes Merkmal darin besteht, daß man mit der vorgenannten Entschichtungslösung arbeitet.

Die Entschichtungslösung und die Anwendung innerhalb des Verfahrens sind wegen der geringen Anteile an organischen Lösemitteln und deren höheren Siedepunkte sowie der als unbedenklich anzusehenden Substanzen der allgemeinen Formel als umweltfreundlich einzustufen.

Die bisher durch den Stand der Technik erzielte Entschichtungsgeschwindigkeit wird nicht herabgesetzt beim Einsatz in den auf dem Markt befindlichen Entschichtungsmaschinen. Außerdem zeigen die Entschichtungslösungen einen weiteren erfindungswesentlichen Vorteil, der darin besteht, daß beim Entschichtungsvorgang keine klebrigen Substanzen anfallen, die die Druckformqualität infolge von Redeponierungen stören. Gleichzeitig entfallen Zeitverluste, die wegen der Reinigung der Apparate entstanden. Weiterhin ist die Belastbarkeit mit abgelöster Schicht sehr hoch, so daß die Entschichtungslösungen hohe Standzeiten aufweisen.

Die folgenden Beispiele sollen die Erfindung erläutern, ohne daß eine Einschränkung hierauf besteht.

Beispiel 1

Auf einen 300 μm dicken Schichtträger aus elektrolytisch aufgerauhtem und anodisch oxidiertem Aluminium wurde eine Lösung von
40 Gt 2-Vinyl-4-(2'-chlor-phenyl)-5-(4"-diethylaminophenyl)-oxazol,
40 Gt eines Mischpolymerisats aus Styrol und Maleinsäureanhydrid mit einem Erweichungspunkt von 210 °C,
0,2 Gt Rhodamin FB (C.I. 45 170) in
510 Gt Tetrahydrofuran,
330 Gt Ethylenglykolmonomethylether und
150 Gt Butylacetat
aufgebracht und zu einer gleichmäßigen Photoleiterschicht mit einem Gewicht von 6 g/m² getrocknet.

Die Platte wurde im Dunkeln mit einer Corona auf etwa -450 V aufgeladen und in einer Reprokamera mit 8 Autophotlampen von je 500 W Sekunden bildmäßig belichtet.

Das entstandene Ladungsbild wurde mit einem Tonerpulver aus
18 Gt eines Mischpolymerisats aus 45 % n-Butylmethacrylat und 65 % Styrol und
2 Gt Rußpigment
entwickelt, und das Tonerbild wurde durch kurzes Erwärmen auf etwa 170 bis 180 °C fixiert. An den Nichtbildstellen wurde die Photoleiterschicht mit folgender Lösung entschichtet:
4 Gt 1-Aminopropanol-2,
2 Gt Trinatriumcitrat
2 Gt Natriumcumolsulfonat,
2,5 Gt Benzylalkohol,
86,5 Gt Wasser.

Die Nichtbildstellen werden sauber entschichtet, der 5%-Punkt (40er Raster) ist voll erhalten. Die Lichter in den Tiefen, 95 % Rasterdeckung, sind offen.

Die ungelösten Schichtbestandteile setzen sich als feine, nicht klebrige Partikel ab. Die Entschichtungsmaschine läßt sich leicht reinigen.


Vergleichsbeispiel 1

Verwendet man in der gleichen Rezeptur statt Natriumcumolsulfonat die gleiche Menge Natriumn-octylsulfat, so erhält man einen ungelösten Anteil in der Maschine, der am Boden des Tanks zusammenklebt und den Reinigungsaufwand erhöht.


Beispiel 2

In gleicher Weise wie in Beispiel 1 läßt sich mit gleich gutem Erfolg in der Entschichtungslösung Natriumcumolsulfonat durch die gleiche Menge Natriumxylolsulfonat oder Natriumbutylmonoglykolsulfat ersetzen. In beiden Fällen erhält man nicht klebende, leicht zu entfernende Rückstände im Tank des Entschichtungsgerätes.

Vergleichsbeispiel 2

Im Vergleich zu Beispiel 2 ergibt Natriumdodecylbenzolsulfonat in der gleichen Menge statt Natriumxylolsulfo nat angewandt einen klebrigen, am Boden haftenden Niederschlag sowie stärkere und stabile Schaumbildung.

Beispiel 3

Als Entschichtungslösung wird, wie in Beispiel 1 beschrieben) eine Lösung aus
4 Gt Aminoethanol,
3 Gt Ethylenglykolmonophenylether,
4 Gt Natriumbenzolsulfonat,
89 Gt Wasser
verwendet.

Die Entschichtung geht einwandfrei. Der im gebrauchten Entschichter ungelöst enthaltene Anteil von Schichtbestandteilen ist nicht klebrig und läßt sich leicht aus der Maschine entfernen.

Beispiel 4

Als Entschichtungslösung gemäß Beispiel 1 wird eine Lösung aus
1 Gt Na$_2$SiO$_3$ x 9H$_2$O,
5 Gt Natriumxylolsulfonat,
2,5 Gt Benzylakohol,
91,5 Gt Wasser
verwendet. Die Entschichtung ergibt einwandfreie Druckformen, der Entschichtertank läßt sich gut reinigen.

Beispiel 5

Auf einen 300 µm dicken Schichtträger aus oberflächlich elektrolytisch aufgerauhtem und anodisch - oxidiertem Aluminium wurde eine Lösung aufgetragen, die
4,5 Gt eines Polyvinylalkohol-Pfropfpolymerisates mit Urethanbackbone (MG - 22.000), das mit n-Butyraldehyd acetalisiert und anschließend mit Bernsteinsäureanhydrid umgesetzt wurde (SZ 58),
4,5 Gt eines Mischpolymerisates aus Styrol und Maleinsäureanhydrid mit einem Erweichungspunkt von 210 °C,
6 Gt 2-Vinyl-4-(2-'-chlorphenyl)-5-(4''-,-diethylaminophenyl)-oxazol,
0,1 Gt Astrazonorange R (G.I. 48040),
0,04 Gt Rhodamin B (G.I. 45170),

45 Gt Ethylenglykolmonomethylether,
20 Gt Butylacetat und
70 Gt Tetrahydrofuran
enthielt. Nach dem Trocknen wurde eine Schicht mit einem Gewicht von 5 g/m$^2$ erhalten.

Die Schicht wurde im Dunkeln mit Hilfe einer Corona auf etwa -450 V aufgeladen und in einer Reprokamera bei Blende 14 12 Sekunden lang belichtet. Als Lichtquelle wurden 10 Halogenstrahler von je 600 Watt verwendet.

Das latente Ladungsbild wurde mit einem Trockentoner entwickelt, durch Wärmeeinwirkung fixiert. Die tonerfreien Bereiche wurden mit folgender Lösung entschichtet:
4 Gt 1-Aminopropanol-2,
2 Gt Trinatriumcitrat,
3 Gt Natriumcumolsulfonat,
91 Gt Wasser.

Die Nichtbildbereiche wurden sauber entschichtet, ohne daß ein klebriger Bodensatz im Tank der Maschine entstand.

Beispiel 6

Als Entschichtungslösung gemäß Beispiel 1 wird eine Lösung aus
3 Gt 1-Aminopropanol-2,
2 Gt Trinatriumcitrat,
5 Gt Natrium-Butylmonoglykolsulfat,
2,5 Gt Benzylalkohol,
0,3 Gt Fettalkoholpolyglykolether (Genapol $^{(R)}$ 0 100 HOECHST AG)
89,3 Gt Wasser,
verwendet.

Die Nichtbildstellen werden sauber entschichtet. Ungelöste Schichtbestandteile sitzen locker am Boden der Entschichtungsmaschine und führen nicht zu Verklebungen.

Die Maschine läßt sich leicht reinigen.

**Ansprüche**

1. wäßrig-alkalische, gegebenenfalls organische Lösemittel enthaltende Entschichtungslösung für die Herstellung von elektrophotographisch erzeugten Druckformen, wobei auf einem elektrisch leitenden, hydrophilen Trägermaterial eine oleophile Photoleiterschicht, die einen Photoleiter und ein Bindemittel mit alkalilöslich oder quellbar machenden Gruppen enthält, angeordnet ist, dadurch gekennzeichnet, daß die Lösung eine Verbindung der allgemeinen Formel R-SO$_3$X enthält, wobei X ein einwertiges Kation ist und worin
A) R = R$^1$ - O[CH$_2$•CH$_2$O]$_n$-, R$^1$ = ein Kohlenwasserstoffrest mit 1 bis 6 C-Atomen und n = 1 bis 6 ist oder

R = Aryl- oder

R = Alkylarylbedeuten und die -SO$_3$X-Gruppe am Glykol- bzw. am Arylrest gebunden ist und

B) einen Anteil von 0 bis 15 Gew.-% an wenigstens einem höher als Wasser siedenden, organischen Lösemittel enthält.

2. Lösung nach Anspruch 1, dadurch gekennzeichnet, daß R$^1$ eine aliphatische Gruppe mit 4 C-Atomen ist.

3. Lösung nach Anspruch 1 oder 2, dadurch gekennzeichnet, daß n = 1 ist.

4. Lösung nach Anspruch 1, dadurch gekennzeichnet, daß die Arylgruppe eine Phenylgruppe ist.

5. Lösung nach Anspruch 1, dadurch gekennzeichnet, daß die Alkylarylgruppe eine mono- oder disubstituierte Phenylgruppe mit 1 bis 3 C-Atomen im Alkylsubstituenten ist.

6. Lösung nach einem der Ansprüche 1 bis 5, dadurch gekennzeichnet, daß der Anteil an organischem Lösemittel 0,1 bis 10,0 Gew.-% beträgt.

7. Lösung nach Anspruch 6, dadurch gekennzeichnet, daß der Anteil an organischem Lösemittel 1,0 bis 5,0 Gew.-% beträgt.

8. Lösung nach einem der Ansprüche 1 bis 7, dadurch gekennzeichnet, daß das organische Lösemittel ein höhersiedender Alkohol oder ein Gemisch von Alkoholen, ein höhersiedender Glykolether oder ein Gemisch von Glykolethern oder ein Gemisch von Alkoholen und Glykolethern ist.

9. Lösung nach einem der Ansprüche 1 bis 8, dadurch gekennzeichnet, daß das organische Lösemittel Benzylakohol, Ethylenglykolmonophenylether, Diethylenglykolmonoethylether oder ein Gemisch davon ist.

10. Lösung nach einem der Ansprüche 1 bis 9, dadurch gekennzeichnet, daß sie als alkalisch machende Substanz anorganische und/oder organische Verbindungen enthält.

11. Lösung nach einem der Ansprüche 1 bis 10, dadurch gekennzeichnet, daß sie die alkalisch machende Substanz in einem Anteil von 0,1 bis 10,0 Gew.-% enthält.

12. Lösung nach Anspruch 9, dadurch gekennzeichnet, daß sie die alkalisch machende Substanz in einem Anteil von 1,0 bis 5,0 Gew.-% enthält.

13. Lösung nach einem der Ansprüche 1 bis 12, dadurch gekennzeichnet, daß die alkalisch machende Substanz ein Aminoalkohol und/oder Natriumsilikat und/oder Natriumcitrat ist.

14. Lösung nach einem der Ansprüche 1 bis 13, dadurch gekennzeichnet, daß sie gegebenenfalls Netzmittel und/oder Entschäumer enthält.

15. Lösung nach Anspruch 14, dadurch gekennzeichnet, daß sie das Netzmittel in einem Anteil von 0,01 bis 2,0 Gew.-% und/oder den Entschäumer in einem Anteil von 0,01 bis 1,0 Gew.-%

enthält.

16. Lösung nach einem der Ansprüche 1 bis 15, dadurch gekennzeichnet, daß sie wenigstens eine Puffersub stanz in einem Anteil von 0,01 bis 0,1 mol/l enthält.

17. Verfahren zur Herstellung einer Druckform, wobei man eine auf einem elektrisch leitenden hydrophilen Trägermaterial befindliche, oleophile Photoleiterschicht, die einen Photoleiter und ein Bindemittel mit alkalilöslich oder quellbar machenden Gruppen enthält, gleichmäßig auflädt, bildmäßig belichtet, betonert und die Tonerschicht thermisch fixiert und anschließend die nicht mit Toner versehene Photoleiterschicht mit einer wäßrig-alkalischen, gegebenenfalls organische Lösemittel enthaltenden Entschichtungslösung entfernt, dadurch gekennzeichnet, daß man mit einer Entschichtungslösung nach einem der Ansprüche 1 bis 16 arbeitet, die eine Verbindung der allgemeinen Formel R-SO$_3$X enthält, wobei X ein einwertiges Kation ist und worin

A) R = R$^1$ - O(CH$_2$ • CH$_2$O)n-, R$^1$ = ein Kohlenwasserstoffrest mit 1 bis 6 C-Atomen und n = 1 bis 6 ist oder

R = Aryl- oder

R = Alkylarylbedeuten und die -SO$_3$X-Gruppe am Glykol- bzw. am Arylrest gebunden ist und

B) einen Anteil von 0 bis 15 Gew.-% an wenigstens einem höher als Wasser siedenden, organischen Lösemittel enthält.